# EUROPEAN PATENT APPLICATION

(11) **EP 4 518 587 A1**
(43) Date of publication of application: **05.03.2025**
(21) Application number: 24195227.4
(22) Date of filing: 19.08.2024
(51) Int. Cl.: H05K 1/02, H05K 1/11, H05K 3/36, H05K 1/14, H05K 1/18, H01L 23/538, H05K 3/28, H05K 3/46

(54) **VIBRATION ISOLATION ASSEMBLIES FOR ELECTRONIC DEVICES**

(30) Priority: 30.08.2023 US 202318458875
(71) Applicant: NXP USA, Inc., Austin, TX 78735 (US)
(72) Inventor: Vincent, Michael B, 5656AG Eindhoven (NL); Hooper, Stephen Ryan, 5656AG Eindhoven (NL); Hayes, Scott M, 5656AG Eindhoven (NL); Daniels, Dwight Lee, 5656AG Eindhoven (NL); Saklang, Chayathorn, 5656AG Eindhoven (NL)
(74) Representative: Hardingham, Christopher Mark

(57) **Abstract**

Vibration isolation can be provided for a vibration sensitive component to be bonded to electronic circuit boards or other surfaces by an assembly that includes two substrates with rigid portions that are electrically coupled to each other via a flexible interconnect. The rigid portions of the two substrates are bonded together via an elastic structure in a stacked arrangement with the first substrate above the second substrate. The flexible interconnect electrically couples the first substrate to the second substrate and the second substrate is configured to be bonded and electrically coupled to an electronic circuit board or other larger substrate via contacts on a surface of the rigid portion of the second substrate. The vibration sensitive component can be bonded to the rigid portion of the first substrate and couped to the flexible interconnect via the first substrate, thereby coupling it to the second substrate and the larger substrate.

## Description

### TECHNICAL FIELD

Embodiments of the subject matter described herein relate to packages for electronic devices including vibration sensitive components.

### BACKGROUND

Electronic devices such as integrated circuits are often packaged in polymer or ceramic housings which can be designed to protect the devices from damage, help dissipate heat, and to provide macroscopic contacts that allow the devices to be coupled to other devices on printed circuit boards and other substrates.

### SUMMARY

In an example embodiment, a system includes an electronic circuit board and a device assembly that is mechanically bonded to the electronic circuit board and electrically coupled to the electronic circuit board. The device assembly includes a first substrate, a second substrate, and a flexible interconnect that electrically couples the first substrate to the second substrate. The first substrate is coupled to the second substrate via an elastic structure disposed between the first substrate and the second substrate that bonds the first substrate to the second substrate. A vibration sensitive electronic device bonded to a rigid portion of the first substrate and electrically coupled to the flexible interconnect via the rigid portion of the first substrate.

In another example embodiment, a device assembly includes a first substrate coupled above a second substrate via an elastic structure disposed between the first substrate and the second substrate that bonds the first substrate to the second substrate. The device assembly also includes a flexible interconnect that electrically couples the first substrate to the second substrate. A first portion of the flexible interconnect is bonded to a rigid portion of the first substrate and the first portion of the flexible interconnect transitions into a middle portion of the flexible interconnect that is free from the rigid portion of the first substrate. The middle portion of the flexible interconnect bends toward the second substrate and transitions to a third portion of the flexible interconnect bonded to a rigid portion of the second substrate. The rigid portion of the first substrate is configured to receive an electronic component and the rigid portion of the second substrate is configured to be bonded and electrically coupled to an electronic circuit board via contacts on a surface of the rigid portion of the second substrate.

In another example embodiment a method includes coupling a first substrate above a second substrate via an elastic structure disposed between the first substrate and the second substrate that bonds the first substrate to the second substrate. A flexible interconnect electrically couples the first substrate to the second substrate. A first portion of the flexible interconnect is bonded to a rigid portion of the first substrate and the first portion of the flexible interconnect transitions into a middle portion of the flexible interconnect that is free from the rigid portion of the first substrate. The middle portion of the flexible interconnect bends toward the second substrate and transitions to a third portion of the flexible interconnect bonded to a rigid portion of the second substrate. The rigid portion of the first substrate is configured to receive an electronic component and the rigid portion of the second substrate is configured to be coupled to an electronic circuit board.

### BRIEF DESCRIPTION OF THE DRAWINGS

The present disclosure is illustrated by way of examples, embodiments and the like and is not limited by the accompanying figures, in which like reference numbers indicate similar elements. Elements in the figures are illustrated for simplicity and clarity and have not necessarily been drawn to scale. The figures along with the detailed description are incorporated and form part of the specification and serve to further illustrate examples, embodiments and the like, and explain various principles and advantages, in accordance with the present disclosure, wherein:
FIG. 1 is a cross-sectional view of a device with vibration isolation features according to one or more embodiments;
FIG. 2 is a cross-sectional view illustrating steps in an example process suitable for use to assemble the device of FIG. 1;
FIG. 3A shows a cross-sectional view[[s]] of a device according to embodiments herein that [[are]]is related to the device of FIG. 1;
FIG. 3B shows a cross-sectional view of another device according to embodiments herein that is related to the device of FIG. 1; and
FIG. 4 is a cross-sectional views of another device according to one or more embodiments.

### DETAILED DESCRIPTION

The following detailed description provides examples for the purposes of understanding and is not intended to limit the invention or the application and uses of the same. Furthermore, there is no intention to be bound by any expressed or implied theory presented in the preceding technical field, background, or the following detailed description.

For simplicity and clarity of illustration, the drawing figures illustrate the general manner of construction, and descriptions and details of well-known features and techniques may be omitted to avoid unnecessarily obscuring the invention. Additionally, elements in the drawing figures are not necessarily drawn to scale. For example, the dimensions of some of the elements or regions in the figures may be exaggerated relative to other elements or regions to help improve understanding of embodiments of the invention.

The terms "first," "second," "third," "fourth" and the like in the description and the claims, if any, may be used for distinguishing between similar elements and not necessarily for describing a particular sequential or chronological order. It is to be understood that the terms so used are interchangeable under appropriate circumstances such that the embodiments of the invention described herein are, for example, capable of operation in sequences other than those illustrated or otherwise described herein. Furthermore, the terms "comprise," "include," "have" and any variations thereof, are intended to cover non-exclusive inclusions, such that a process, method, article, or apparatus that comprises a list of elements is not necessarily limited to those elements but may include other elements not expressly listed or inherent to such process, method, article, or apparatus. The term "coupled," as used herein, is defined as directly or indirectly connected in an electrical or non-electrical manner. As used herein the terms "substantial" and "substantially" mean sufficient to accomplish the stated purpose in a practical manner and that minor imperfections, if any, are not significant for the stated purpose.

Directional references such as "top," "bottom," "left," "right," "above," "below," and so forth, unless otherwise stated, are not intended to require any preferred orientation and are made with reference to the orientation of the corresponding figure or figures for purposes of illustration.

Unless explicitly stated otherwise, the use of terms "approximately," "substantially" and similar terms in connection with dimensions, relative positioning, or orientation of various features indicates that the dimensions, positioning, or orientation of those features are subject to tolerances and/or expected process variations of equipment and processes chosen to form the described features. Unless explicitly stated otherwise, the use of terms "approximately," "substantially" and similar terms in connection measurable values or characteristics is subject to the expected measurement accuracy of equipment and methods used to measure those values or characteristics and/or within tolerance limits specified by technical standards applicable to the technologies described.

It will be appreciated that the steps of various processes described herein are non-limiting examples of suitable processes according to embodiments and are for the purposes of illustration. Embodiments herein may use any suitable processes including those that omit steps described herein, perform those steps and similar steps in different orders, and the like. It will also be appreciated that well-known features and techniques may be omitted for clarity.

Conventional techniques for packaging and encapsulating electronic devices are capable of protecting devices from mechanical damage and degradation resulting from exposure to the surrounding environment. However, requirements for communication with other devices in larger systems (e.g., those formed by many individual components on electronic circuit boards such as printed circuit boards) and mechanical and thermal requirements for such systems often necessitate rigidly coupling devices to larger substrates. When the underlying substrates are exposed to mechanical vibration, the vibration can be strongly coupled to individual devices on the substrate(s).

Accordingly, embodiments herein enable the integration of vibration sensitive devices onto conventional substrates such as printed circuit boards while providing vibration isolation of such vibration-sensitive components from the printed circuit board (or other structures) which they are coupled to.

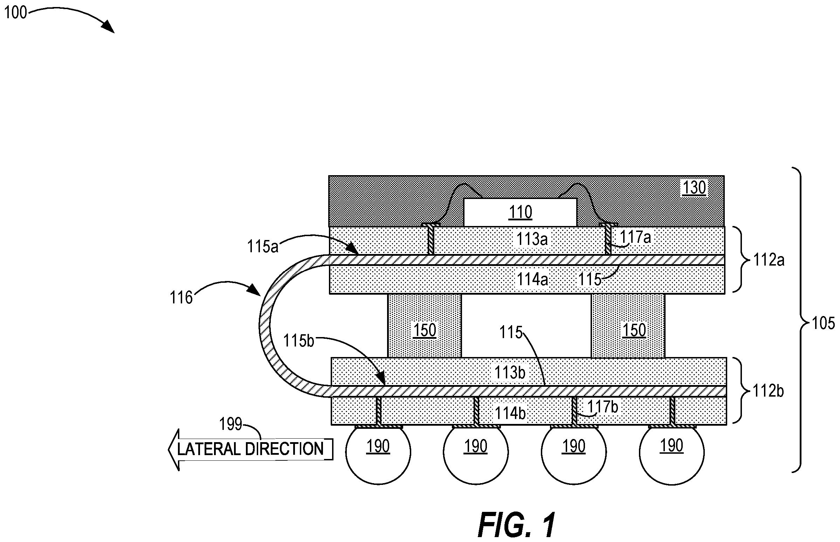

Along these lines, FIG. 1 is a cross-sectional view of an example system according to one or more embodiments. The system 100 includes an electronic circuit board 102 to which an assembly 105 is mechanically and electrically coupled. In this example, the assembly 105 is depicted being coupled to the circuit board 102 via solder bumps 190. However, it will be understood that structures such as the assembly may be coupled to substrates such as the circuit board 102 or other substrates using any suitable approach including, but not limited to solder reflow, thermocompression bonding, the use of electrically-conductive adhesives, and the like.

The assembly 105 includes two substrates 112a, 112b which are depicted in FIG. 1 as three-layer substrates (e.g., printed circuit boards) which include respective rigid portions (the rigid portions 113a, 114a of the substrate 112a and the rigid portions 113b, 114b of the substrate 112b). The substrates 112a, 112b are electrically coupled to each other by a flexible electrical interconnect (i.e., the flexible interconnect 115). A first portion 115a of the flexible interconnect 115 is bonded to one or more of the rigid portions of the substrate 112a and a second portion 115b of the flexible interconnect 115 is bonded to one or more of the rigid portions of the substrate 112b. As shown in FIG. 1, the first portion 115a of the flexible interconnect 115 extends along a lateral direction indicated by the arrow 199. The flexible interconnect 115 extends away from the substrate 112a along the lateral direction and transitions to a middle portion 116 that bends toward the substrate 112b and transitions to the second portion 115b of the flexible interconnect 115.

A vibration sensitive device (the device 110) is mechanically and electrically coupled to the first substrate 112a and encapsulated within a volume of molding material 130. For purposes of illustration the device 110 is shown electrically coupled to the flexible interconnect 115 via wire bonds coupled to conductive vias 117a that pass through the rigid portion 113a of the substrate 112a. However, it will be understood that devices such as the device 110 may be electrically coupled to substrates such as the substrate 112a and to flexible interconnects such as the flexible interconnect 115 by any suitable methods. For instance, the device 110 could be soldered to conductive pads or bonded to conductive pads or similar features using an electrically-conductive adhesive, as nonlimiting examples. It will also be understood that although the device 110 and similar devices may be depicted as monolithic structures they are not limited to discrete die. For example, devices such as the device 110 and related devices can include multiple semiconductor die or other device die bonded together in any suitable arrangement including, but not limited to, multiple device die bonded together in one or more vertical stacks.

The substrate 112a is mechanically coupled to the substrate 112b via an elastic support structure (e.g., a suitably elastic flexible adhesive 150). The flexible adhesive 150 can be arranged between the substrates 112a, 112b in any suitable manner, including but not limited to, one or more individual volumes of material of any suitable dimensions and shapes such as one or more discrete rectangles, one or more rectangles, one or more circles, an annulus, and so on. The flexible adhesive 150 can be configured to reduce coupling of vibration from the circuit board 102 and/or the substrate 112b at a desired frequency or in one or more desired frequency ranges. For example, the flexible adhesive may be configured to have a particular elastic modulus suitable for providing a desired amount of vibration dampening at the desired frequency or frequency range. The flexible adhesive 150 can be any suitable material including, as nonlimiting examples: silicone-based adhesives, polyurethane-based adhesives, combinations thereof, and the like. The elastic modulus of the flexible adhesive 150 may also be tuned by varying its composition (e.g., by the inclusion of filler materials to stiffen or soften the flexible adhesive 150). In one or more embodiments, a prefabricated elastic structure is adhered to the substrates 112a, 112b and functions similarly to the flexible adhesive 150 as described above.

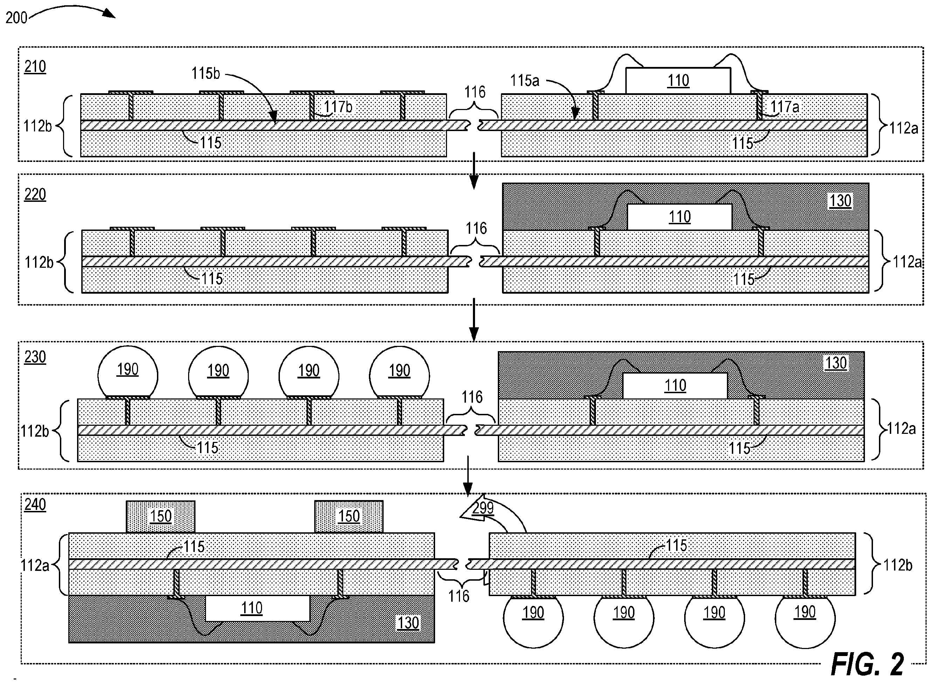

FIG. 2 is a cross-sectional view of the substrates 112a, 112b during steps in an example process 200 for forming the assembly 105 shown in FIG. 1. The process 200 includes the steps 210, 220, 230, and 240 and is described below with reference to the assembly 105 of FIG. 1.

At step 210, the substrates 112a, 112b are oriented as shown, allowing the die device 110 to be bonded to the substrate 112a and (in this example) electrically coupled to the substrate 112a via wire bonds to bond pads that are electrically coupled to the vias 117a in the substrate 112a. The vias 117a are in turn coupled to the flexible interconnect 115 which is connected to the vias 117b within the substrate 112b.

At step 220, the volume of molding material 130 is deposited above the device 110 and above the top surface of 112a, encapsulating device 110 and at step 230, the solder bumps 190 are bonded to the substrate 112b. The molding material 130 may be a thermally or optically cured polymer material. In one or more embodiments, a device such as the device 110 may be received as a pre-molded package which can be soldered or otherwise bonded to a substrate such as the substrate 112a, and a molding step such as the step 220 is not required.

At step 240, the flexible adhesive 150 is applied to the side of the substrate 112a opposite the device 110. Step 240 may be performed with the substrates 112a, 112b inverted as shown relative to their orientations during steps 210-230. After step 240, the substrates 112a, 112b can be folded together as indicated by the arrow 299, bonding them to each other via the flexible adhesive 150. Once the substrates 112a, 112b are folded and bonded to each other to form the assembly 105 as shown in FIG. 1, the assembly 105 can be bonded to a substrate such as the circuit board 102 of FIG. 1 or any other suitable structure (e.g., via the solder bumps 190 or any other suitable structures).

Various structures such as conductive vias, bond pads, and the like on and within the substrates 112a, 112b can be formed using any suitable methods including lithographic and/or other suitable processes. The substrates 112a, 112b may be received as a single substrate having rigid portions to which the flexible interconnect 115 is bonded. The rigid portions may then be selectively removed (e.g., prior to step 210) to expose the middle portion 116 of the flexible interconnect 115. Alternatively, the substrates 112a, 112b may be independent substrates which are joined together by the middle portion 116 of the flexible interconnect 115. As a nonlimiting example, the substrates 112a, 112b may be bonded to a prefabricated flexible interconnect or portions of flexible interconnects belonging to each substrate may be bonded together to form the middle portion 116 of the flexible interconnect 115. The substrates 112a, 112b may be patterned as shown using any suitable process and in any suitable order before being folded together as indicated by the arrow 299 and bonded to each other by the flexible adhesive 150.

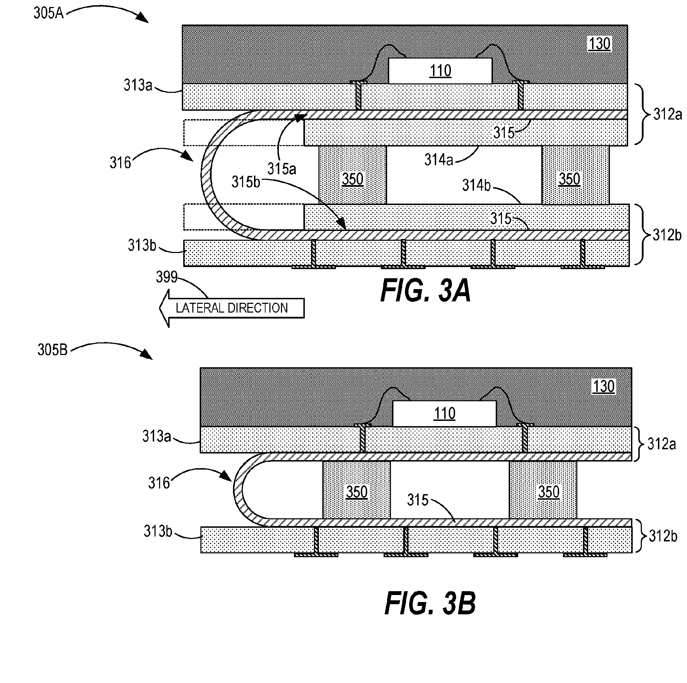

Embodiments herein include assemblies related to the assembly 105 with various features that differ from the assembly 105. For example, in the assembly 305A of FIG. 3A, the upper substrate to which the device 110 is coupled (the substrate 312a) includes a first rigid portion 313a (e.g., the rigid portion 113a of the assembly 105) and a second rigid portion 314a that is patterned such that the first rigid portion 313a extends farther along the lateral direction indicated by the arrow 399 than the second rigid portion 314a. The lower substrate (the substrate 312b) is similarly patterned with a first rigid portion 313b that is longer than its second rigid portion 314b as shown. As a result, when the substrates 312a, 312b are folded together and bonded to each other via the flexible adhesive 350 (e.g., the flexible adhesive 150), the middle portion 316 of the flexible interconnect 315 (e.g., the flexible interconnect 115), underlies the first rigid portion 313a of the substrate 312a and overlies the first rigid portion 313b of the substrate 312b. This arrangement can help protect the exposed middle portion 316 of the flexible interconnect 315 from accidental damage.

FIG. 3B illustrates another example assembly according to one or more embodiments. The assembly 305B differs from the assembly 305A in that the substrates 312a, 312b each include one rigid portion (the respective rigid portions 313a, 313b) rather than two. As shown in FIG. 3B the middle portion 316 of the flexible interconnect 315 is positioned analogously to the position of the flexible interconnect 315 in the assembly 305A. However, it should be understood that the flexible interconnect 315 or similar flexible interconnects can be disposed in any suitable manner. For instance, in one or more embodiments, the middle portion of a flexible interconnect such as the middle portion 316 of the flexible interconnect 315 can protrude in a lateral direction (i.e., such as the lateral direction indicated by the arrow 399) beyond the extent of a substrate such as the substrate 312a and/or the substrate 312b (e.g., analogously to the middle portion 116 of the flexible interconnect 115 as depicted in FIG. 1) along the lateral direction.

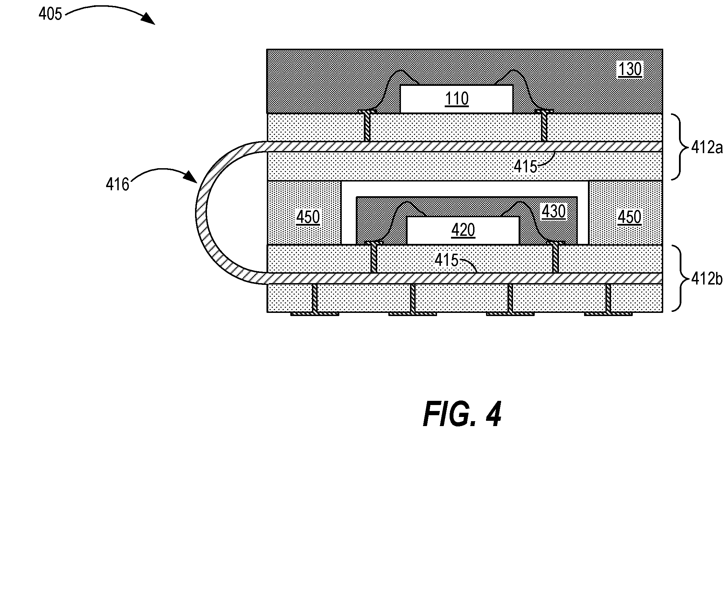

Assemblies according to embodiments herein are not limited to a single device such as the device 110. For example, any suitable number of additional devices can be disposed on an "upper" substrate that includes a vibration sensitive device such as the device 110 (e.g., a substrate 112a, 312a). In addition, as illustrated by the assembly 405 of FIG. 4, a device 110 can be bonded to a substrate 412a (e.g., a substrate 112a or 312a) and electrically coupled to a flexible interconnect 415 (e.g., a flexible interconnect 115 or 315) and one or more additional devices (e.g., the device 420) can be bonded and electrically coupled to a "lower" substrate 412b (e.g., a substrate 112b or 312b). In the example of FIG. 4, the device 420 is encapsulated within a volume of molding material 430 (e.g., the molding material 130 or any other suitable material) and disposed on the substrate 412b in between volumes of the flexible adhesive 450 (e.g., the flexible adhesive 150 or 350). The volume of molding material 430 is configured such that it does not interfere with the vibration isolation provided by the flexible adhesive 450 (i.e., the volume of molding material 430 does not contact the substrate 412a).

It will be appreciated that the assembly 405 (in addition to the assemblies 105, 305A, and 305B) is a non-limiting example according to embodiments herein. For example, in one or more embodiments, a device such as the device 420 is bonded to a substrate such as the substrate 412b without being encapsulated. In one or more other embodiments, a substrate such as the substrate 412b extends beyond the position(s) of a flexible adhesive such as the flexible adhesive 450. In one or more such embodiments, one or more devices such as the device 420 are positioned away from the flexible adhesive (i.e., rather than surrounded by the flexible adhesive as shown in FIG. 4). In addition, in one or more embodiments, an additional device such as the device 420 is disposed on an opposite side of the same substrate from a device such as the device 110 (i.e., the device 420 could be disposed on the underside of an upper substrate such the substrate 412a rather than on a lower substrate such as the substrate 412b as shown).

### VARIOUS EXAMPLES

Features of embodiments may be understood by way of one or more of the following examples:
Example 1: A device, system, or method that includes a device assembly that is configured to be bonded to the electronic circuit board and electrically coupled to an electronic circuit board. The device assembly includes a first substrate having a rigid portion, a second substrate having a rigid portion, and a flexible interconnect that electrically couples the first substrate to the second substrate. The first substrate is coupled to the second substrate via an elastic structure disposed between the first substrate and the second substrate that bonds the first substrate to the second substrate.
Example 2: The device, system, or method of Example 1 in which a vibration sensitive electronic device bonded to a rigid portion of the first substrate and electrically coupled to the flexible interconnect via the rigid portion of the first substrate.
Example 3: The device, system, or method of Example 1 or Example 2 where the device assembly includes a volume of molding material disposed on the rigid portion of the first substrate that encapsulates the vibration sensitive electronic device.
Example 4: The device, system, or method of any of Examples 1-3, where the flexible interconnect is a continuous polymer structure that includes one or more flexible metallic traces that electrically couple the first substrate to the second substrate.
Example 5: The device, system, or method of any of Examples 1-4, where a first portion of the flexible interconnect is bonded to the rigid portion of the first substrate and the first portion of the flexible interconnect transitions into a middle portion of the flexible interconnect that is free from the rigid portion of the first substrate. The middle portion of the flexible interconnect is bent toward the second substrate and transitions to a third portion of the flexible interconnect bonded to a rigid portion of the second substrate.
Example 6: The device, system, or method of any of Examples 1- 5, where the rigid portion of the first substrate extends along a lateral dimension by a first distance such that it overhangs an entirety of the middle portion of the flexible interconnect along the lateral dimension.
Example 7: The device, system, or method of any of Examples 1-6 that includes an additional electronic device disposed on the rigid portion of the second substrate and electrically coupled to the second substrate.
Example 8: The device, system, or method of any of Examples 1-7, where an additional electronic device is electrically coupled to the first substrate via the flexible interconnect.
Example 9: The device, system, or method of any of Examples 1-8 where the rigid portion of the second substrate bonded and electrically coupled to an electronic circuit board via contacts on a surface of the rigid portion of the second substrate.
Example 10: The device, system, or method of any of Examples 1-9 in which a rigid layer of a circuit substrate is selectively removed to expose a flexible interconnect and separate the circuit substrate into a first substrate and a second substrate that are coupled together by the flexible interconnect.

The preceding detailed description and examples are merely illustrative in nature and are not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no Intention to be bound by any expressed or implied theory presented in the preceding technical field, background, or detailed description.

It should be understood that this invention is not limited in its application to the details of construction and the arrangement of components set forth in the preceding description or illustrated in the accompanying drawings. The invention is capable of other embodiments and of being practiced or of being carried out in various ways. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

The preceding discussion is presented to enable a person skilled in the art to make and use embodiments of the invention. Various modifications to the illustrated embodiments will be readily apparent to those skilled in the art, and the generic principles herein can be applied to other embodiments and applications without departing from embodiments of the invention. Thus, embodiments of the invention are not intended to be limited to embodiments shown, but are to be accorded the widest scope consistent with the principles and features disclosed herein. The preceding detailed description is to be read with reference to the figures, in which like elements in different figures have like reference numerals. The Figures, which are not necessarily to scale, depict selected embodiments and are not intended to limit the scope of embodiments of the invention. Skilled artisans will recognize the examples provided herein have many useful alternatives and fall within the scope of embodiments of the invention.

The connecting lines shown in the various figures contained herein are intended to represent exemplary functional relationships and/or physical couplings between the various elements. It should be noted that many alternative or additional functional relationships or physical connections may be present in one or more embodiments of the subject matter. In addition, certain terminology may also be used herein for the purpose of reference only, and thus are not intended to be limiting, and the terms "first," "second" and other such numerical terms referring to structures do not imply a sequence or order unless clearly indicated by the context.

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in one or more embodiments of the depicted subject matter.

## Claims

1. A system comprising:
an electronic circuit board and a device assembly that is mechanically bonded to the electronic circuit board and electrically coupled to the electronic circuit board;
wherein the device assembly comprises:
a first substrate coupled to a second substrate via an elastic structure disposed between the first substrate and the second substrate that bonds the first substrate to the second substrate;
a flexible interconnect that electrically couples the first substrate to the second substrate; and
a vibration sensitive electronic device bonded to a rigid portion of the first substrate and electrically coupled to the flexible interconnect via the rigid portion of the first substrate.

2. The system of claim 1,
wherein the device assembly comprises a volume of molding material disposed on the rigid portion of the first substrate that encapsulates the vibration sensitive electronic device.

3. The system of claim 1 or 2,
wherein the flexible interconnect is a continuous polymer structure that includes one or more flexible metallic traces that electrically couple the first substrate to the second substrate.

4. The system of claim 3,
wherein a first portion of the flexible interconnect is bonded to the rigid portion of the first substrate and the first portion of the flexible interconnect transitions into a middle portion of the flexible interconnect that is free from the rigid portion of the first substrate; and
wherein the middle portion of the flexible interconnect bends toward the second substrate and transitions to a third portion of the flexible interconnect bonded to a rigid portion of the second substrate.

5. The system of claim 4,
wherein the rigid portion of the first substrate extends along a lateral dimension by a first distance such that it overhangs an entirety of the middle portion of the flexible interconnect along the lateral dimension.

6. The system of any preceding claim, wherein the device assembly further comprises:
an additional electronic device disposed on the second substrate and electrically coupled to the second substrate.

7. The system of claim 6, wherein the additional electronic device is electrically coupled to the first substrate via the flexible interconnect.

8. A method comprising:
coupling a first substrate above a second substrate via an elastic structure disposed between the first substrate and the second substrate that bonds the first substrate to the second substrate;
wherein a flexible interconnect electrically couples the first substrate to the second substrate;
wherein a first portion of the flexible interconnect is bonded to a rigid portion of the first substrate and the first portion of the flexible interconnect transitions into a middle portion of the flexible interconnect that is free from the rigid portion of the first substrate;
wherein the middle portion of the flexible interconnect bends toward the second substrate and transitions to a third portion of the flexible interconnect bonded to a rigid portion of the second substrate;
wherein the rigid portion of the first substrate is configured to receive an electronic component; and
wherein the rigid portion of the second substrate is configured to be coupled to an electronic circuit board.

9. The method of claim 8, further comprising bonding a vibration sensitive electronic device to the rigid portion of the first substrate and electrically coupling the vibration sensitive device to the flexible interconnect via the rigid portion of the first substrate.

10. The method of claim 9, further comprising forming a volume of molding material disposed on the rigid portion of the first substrate that encapsulates the vibration sensitive electronic device.

11. The method of claim 8 or 9, further comprising bonding an additional electronic device on the rigid portion of the second substrate and electrically coupling the additional device to the second substrate.

12. The method of any of claims 8 to 11, further comprising:
receiving a circuit substrate having a rigid layer bonded to the flexible interconnect; and
selectively removing the rigid layer of the circuit substrate to expose the flexible interconnect and separate the circuit substrate into the first substrate and the second substrate.

13. The method of any of claims 8 to 12, wherein coupling the first substrate above the second substrate comprises:
disposing the elastic structure on the rigid portion of the first substrate or on the rigid portion of the second substrate; and
folding the first substrate over the second substrate such that the rigid portions of the first and second substrates are bonded to each other.

14. The method of any of claims 8 to 13, wherein the rigid portion of the first substrate extends along a lateral dimension by a first distance such that it overhangs an entirety of the middle portion of the flexible interconnect along the lateral dimension.
